# EUROPÄISCHE PATENTSCHRIFT

(11) **EP 1 026 932 B1**
(45) Veröffentlichungstag und Bekanntmachung des Hinweises auf die Patenterteilung: **30.03.2005**
(21) Anmeldenummer: 00101757.3
(22) Anmeldetag: 28.01.2000
(51) Int. Cl.: H05K 7/18, H02B 1/30, H05K 7/20

(54) **Modulares Schaltschranksystem zur Aufnahme elektrischer und elektronischer Aggregate**
Modular cabinet for electrical and electronic aggregates
Armoire modulaire d'agrégats électriques ou électroniques

(30) Priorität: 03.02.1999 DE 29901658 U; 19.04.1999 DE 19917641
(43) Veröffentlichungstag der Anmeldung: 09.08.2000
(73) Patentinhaber: Burn, Heinz, 4655 Stüsslingen (CH)
(72) Erfinder: Burn, Heinz, 4655 Stüsslingen (CH)
(74) Vertreter: Dr. Weitzel & Partner

(56) Entgegenhaltungen:
- EP-A- 0 312 372
- DE-A- 3 326 977
- DE-A- 3 717 540
- DE-C- 19 641 552
- DE-U- 8 914 551
- PFENDER: "Eine kühle Sache Klimatisieren elektronischer Systeme" ELEKTROTECHNIK, Bd. 72, Nr. 7/8, 30. August 1990 (1990-08-30), Seiten 42-49, XP000159472 Wurzburg, DE
- HANS-JÜRGEN HEINRICH: "Easy Cooling of Equipment Cubicles" SIEMENS POWER ENGINEERING & AUTOMATION, Bd. 6, Nr. 3, September 1986 (1986-09), Seiten 20-24, XP002147401 Berlin Germany
- VON P. MAZURA, STRAUBENHARDT: "Kühlsysteme in der Anwendung für 19" -Elektronikschränke" FEINWERKTECHNIK & MESSTECHNIK, Bd. 92, Nr. 7, Oktober 1984 (1984-10), Seiten 331-333, XP002147402 München, DE

## Beschreibung

Die Erfindung betrifft ein modulares Schaltschranksystem zur Aufnahme elektrischer oder elektronischer Aggregate.

Schaltschränke gemäß dem Stand der Technik umfassen einen Korpus, der einen die Aggregate enthaltenden Innenraum umschließt. Der Korpus weist in üblicher Weise einen Boden, ein Dach sowie Umfangswände auf. Die Umfangswände umfassen ihrerseits zwei Seitenwände, eine Rückwand sowie eine Frontwand. Die Frontwand enthält üblicherweise eine Tür.

Nur beispielshalber wird verwiesen auf die Zeitschrift "Maschinenmarkt" Nr. 28 vom 08.07.1996 sowie den dort abgedruckten Aufsatz "Übertemperaturen in Schaltschränken bei hoher Umgebungswärme mit Kühlgeräten sicher vermeiden".

Die in Schalt- oder Steuerschränken enthaltenen Aggregate erzeugen Wärme. Der Innenraum solcher Schaltschränke ist im allgemeinen hermetisch abgeschlossen, um den Zutritt von Staub, Feuchtigkeit oder anderen schädlichen Medien zu vermeiden. Würden im Hinblick auf diesen Wärmeanfall keine Vorkehrungen getroffen, so würde sich ein Wärmestau einstellen. Die Abfuhr von Wärme ist daher dringend geboten.

Zu diesem Zweck ist es bekannt, Schaltschränke oder Steuerschränke mit Kühlanlagen bzw. Klimageräten zu versehen. Die Kühlanlagen dienen dem Zweck, die Luft im Schaltschrank umzuwälzen und dabei abzukühlen. Kühlanlagen umfassen gemäß dem Stand der Technik beispielsweise ein Kühlaggregat, ferner einen Wärmetauscher mit Lüftergruppe für die Luftzirkulation im Innenraum des Schaltschrankes. Die gesamte Kühlanlage wird in der Frontwand bzw. Türe oder einer Seitenwand des Schrankes angeordnet. Nur beispielhaft wird auf die nachfolgenden Schriften verwiesen:
DE-A-34 36 407
US-PS-5 467 250
DE-A-196 01 456
DE-A-3 504 207
DE-U-88 10 228.

DE-PS 34 36 407 zeigt ein Klimagerät, das in den Innenraum des Schaltschrankes eingeschoben werden kann. Dies hat den Nachteil, daß für Einbauten weniger Platz im Innenraum des Schaltschrankes zur Verfügung steht.

Aus der US-PS 5 467 250 ist ein Schaltschrank bekannt geworden, bei dem ein Wärmetauscher in der Schaltschranktür untergebracht ist.

Die DE-A-196 01 456 zeigt einen klimatisierten Schaltschrank mit in die Türe oder in ein Wandelement integriertes Klimagerät oder Wärmetauscher, wobei das Wandelement oder die Schranktür als Gehäuse zur Aufnahme der Komponenten des Klimagerätes und/oder des Wärmetauschers ausgebildet sind.

Es ist auch bekannt, ein Klimagerät auf der Außenseite einer Schaltschrankwand aufzubringen. Eine derartige Anordnung zeigt die DE 35 04 207 oder auch die DE-U 88 10 228.

Ein Nachteil einer Anordnung gemäß der DE 35 04 207 oder der DE-U 88 10 228 ist, daß bei diesen Schaltschränke ein Anbau unterschiedlicher Kühlgeräte durch einfachen Tausch der eingesetzten Kühlaggregate, d.h. lediglich durch An- oder Abbau nicht möglich war. Grund hierfür war, daß der beim Einsatz einer Luft-Luft-Kühleinrichtung anstelle der in der DE 35 04 207 oder der DE-U 88 10 228 offenbarten Klimageräte die Kühlleistung des Gerätes stark abnahm und keine ausreichende Kühllleistung mehr erzielt wurde. Beim Tausch einer Art von Kühleinrichtung gegen eine andere mussten daher die Schaltschränke stets individuell bearbeitet werden.

Die individuelle Bearbeitung ist aber sehr zeitaufwendig, eine Vorfertigung ist praktisch nicht möglich. Ebensowenig ist ein einfaches Austauschen einer Kühleinrichtung, beispielsweise eines Luft-Luft-Wärmetauschers gegen einen Luft-Wasser-Wärmetauscher nicht möglich. Bei Ausfall des angebauten Kühlgerätes mußte zudem der gesamte Schaltschrank außer Betrieb gesetzt werden, ein Notbetrieb war nicht möglich.

Aufgabe ist es somit, ein Schaltschranksystem zur Aufnahme elektrischer und elektronischer Aggregate anzugeben, mit dem die zuvor genannten Nachteile überwunden werden können.

Diese Aufgabe wird durch ein Schaltschranksystem gemäß Anspruch 1 gelöst.

Die Erfinder haben erkannt, daß die gestellte Aufgabe nur durch ein modulares System gelöst werden kann, das es erlaubt, stets ein und dasselbe Modell des Schrankkorpus zu verwenden und lediglich durch Anbringen unterschiedlicher Kühl- oder Klimamodule auf dem vorbestimmten Montagebereich des Schaltschrankes unterschiedliche Kühlsysteme zu realisieren. Hierfür ist es notwendig das erste Modul des Systems umfassend den Schrankkorpus mit mindestens einer genormten Öffnung zu versehen, die derart dimensioniert ist, daß bei Anbau unterschiedlicher Kühl- oder Klimaaggreagte stets eine ausreichende vorbestimmte Kühlleistung von beispielsweise 60 W/° T realisiert wird.

Der entscheidende Vorteil des modularen Aufbaus des erfindungsgemäßen modularen Schaltschranksystems gegenüber den Schaltschränken des Standes der Technik, die nur für ein einziges Kühl- oder Klimamodul dimensioniert wurden ist die Flexibilität des modularen Systems.

Es können nämlich je nach Bedarf Kühl- oder Klimamodule unterschiedlicher Kapazitäten und unterschiedlicher Technologien als zweites Modul auf den Schrankkorpus als erstes Modul im vorbestimmten Montagebereich aufgesetzt werden. Das erste Modul bzw. der Korpus kann in größeren Stückzahlen auf Lager gehalten werden. Bei Bedarf, d. h. bei Bestellungen durch einen Kunden, können die einzelnen Schaltschränke bestehend aus erstem und zweitem Modul dadurch fertiggemacht werden, daß jeweils der Schrankkorpus als erstes Modul mit dem geeigneten Kühl- oder Klimamodul als zweitem Modul bestückt wird. Der Anbau eines Kühlmoduls geschieht im allgemeinen durch einfaches Befestigen des Kühl- oder Klimamodules an vorbestimmten Befestigungsstellen im Montagebereich, beispielsweise mittels von Schrauben am erfindungsgemäßen Schrankkorpus. Die entsprechenden Kühl- oder Klimamodule können ohne Fachkenntnisse und ohne Spezialwerkzeuge eingesetzt bzw. ausgetauscht werden.

Ganz entscheidend für die Erfindung ist, daß von kompletten Kühl- oder Klimaeinrichtungen für unterschiedliche Einsatzzwecke, wie sie bislang in Schaltschränken zur Klimatisierung eingesetzt wurden, abgegangen wird und das Kühlsystem im wesentlichen in zwei Teilsysteme aufgespalten wird. Das erste Teilsystem oder das erste Modul umfaßt den Schaltschrankkorpus mit mindestens einer genormten Öffnung im Deckel oder den Umfangswänden des Schaltschrankes in einem vorbestimmten Montagebereich. Diese Öffnung stellt die Verbindung zwischen Schrankinnerem und Kühl- oder Klimamodul als zweitem Teilsystem oder zweitem Modul her. In einer speziellen Ausgestaltung der Erfindung sind mindestens zwei genormte Öffnungen in einer Umfangswand, dem Boden oder der Deckelwand vorgesehen. Bei einem derartigen System kann in eine der genormten Öffnungen des ersten Teilsystems ein Filter, in die andere ein Lüfter, eingesetzt werden, so daß ein einfaches Filter-Lüfter-System ausgebildet wird. Dieses stellt eine gewisse Kühlkapazität zur Verfügung und stellt bei angebautem Kühlmodul bei dessen Ausfall wenigstens eine Notlauffunktion, das bedeutet eine Notkühlung des Schaltschrankes, sicher.

Das zweite Teilsystem oder das zweite Modul des modularen Kühlsystems stellt das Kühl- oder Klimamodul dar, wobei mit den erfindungsgemäß im Montagebereich des Schaltschrankes ausgebildete(n) genormte(n) Öffnung(en) wenigstens eine der nachfolgend genannten Kühleinrichtungen ausgebildet wird:
- eine Luft-Luft-Kühleinrichtung;
- eine Luft-Wasser-Kühleinrichtung;
- eine Luft-Kältemittel-Kühleinrichtung;
- eine Klimaeinrichtung mit Heizung;
- eine Heat-Pipe-Kühleinrichtung;
- eine Kälteelement-Kühleinrichtung;
- oder eine Kombination aus mehreren der obengenannten Kühleinrichtungen.

Wie zuvor aufgezeigt, wird durch den modularen Aufbau nicht nur ein Vorteil in Bezug auf die einfache Tauschbarkeit und Ausrüstbarkeit von Schaltschränken für die unterschiedlichsten Einsatzbereiche erzielt, sondern auch die Stillstandszeiten des gesamten Schaltschranksystems bei Ausfall von Kühl- oder Klimaeinrichtungen minimiert bzw. vollständig vermieden, da ohne größere Umbauarbeiten eine Lüfter-Filter-Kühleinrichtung zur Verfügung gestellt werden kann. In einer bevorzugten Ausführungsform der Erfindung ist vorgesehen, daß der Schaltschrankkorpus einen Sockelraum umfaßt.

In einer derartigen Ausgestaltung kann vorgesehen sein, eine Kühlanlage, beispielsweise umfassend einen Luft-Luft- oder einen Luft-Wasser-Wärmetauscher sowie eine Klimagerät im Sockelraum platzsparend anzuordnen. Der Kühlluftstrom wandert dann vom Sockelraum durch den Innenraum des Schrankes nach oben in den Deckelraum und zurück wieder in den Sockelraum.

In einer bevorzugten Ausgestaltung der Erfindung kann vorgesehen sein, eine Montageplatte im Schrankinnern parallel zu einer Umfangswand vorzusehen, wobei ein Zwischenraum zwischen Montageplatte und Umfangswand ausgebildet wird. Ist im Sockelraum oder auch dem Dach, wie beschrieben, eine Kühl- bzw. Klimaanlage untergebracht, so kann mit Vorteil der Zwischenraum zwischen Montageplatte und Rückwand in geschickter Weise als Strömungskanal ausgenutzt werden. Es können saugende bzw. drückende Lüfter für die Luftzirkulation verwendet werden.

Besonders bevorzugt finden im Sockelraum als Lüfter saugende Lüfter Verwendung. Diese Art der Lüfter hat den Vorteil, daß die Lamellen des Wärmetauschers gleichmäßig von Luft umströmt werden, was zu einem besseren Wirkungsgrad führt.

Eine einfach auszuführende konstruktive Lösung liegt vor, wenn als Lüfter Axiallüfter verwendet werden.

In einer weitergebildeten Ausführungsform für größere Schrankkombinationen wird vorgeschlagen, im Sockel unterzubringende Lüfter und Wärmetauscher zu einer Kühl- oder Klimakassette zusammenzufassen, die in im Schrankksockel eingelassene Einschuböffnung(en) leicht eingeschoben und herausgenommen werden können.

Die Kühlkassetten können sowohl eine Luft-Luft-, eine Luft-Wasser- oder eine Verflüssiger-/Kompressor-Kühleinrichtung oder eine Klimaeinrichtung darstellen.

Die Erfindung soll nachfolgend anhand der Zeichnungen beispielhaft beschrieben werden. Es zeigt:
- Fig. 1: eine erste Ausführungsform eines erfindungsgemäßen Schaltschranksystems mit sämtlichen möglichen Ausführungsvarianten von am Schrankkorpus und im Schaltschranksockel angeordneten bzw. anbaubaren Kühlmodulen.
- Fig. 2: eine zweite Ausführungsform eines erfindungsgemäßen Schaltschranksystems mit möglichen Ausführungsvarianten von am Schrankkorpus und im Schranksockel anordnenbaren bzw. anbaubaren Kühlmodulen.

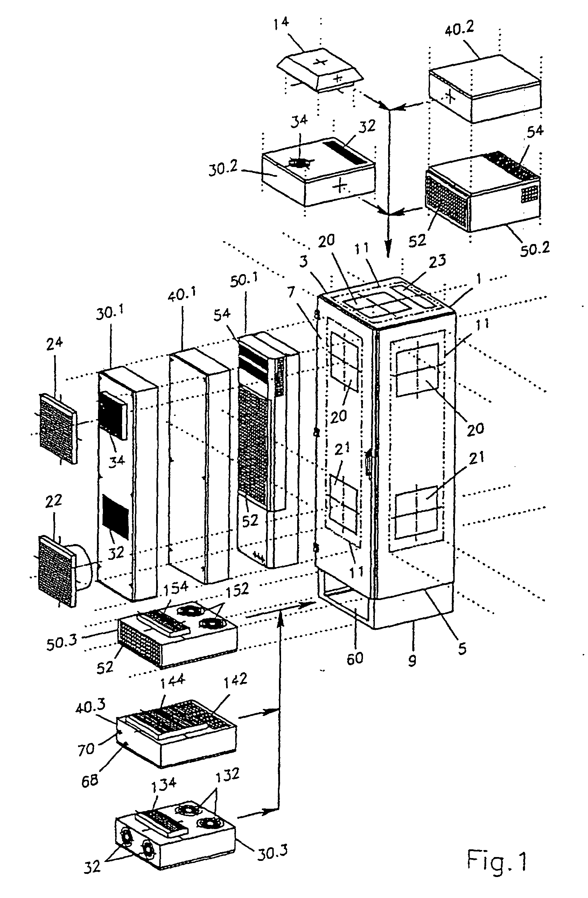

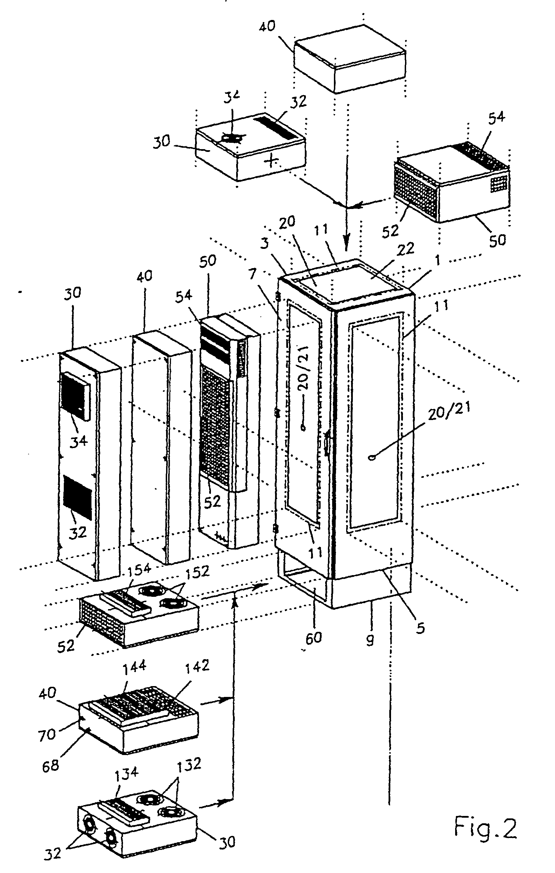

Das in Fig. 1 wie auch Fig. 2 gezeigte Schaltschranksystem zeichnet sich dadurch aus, daß Normöffnungen 20 und 21 in einer oder mehrerer der vier Umfangswände bzw. in der Deckelwand 20 und 23 sowie im Sockel 60 zugebracht sein können. Die Normöffnungen 20, 21 und 23 stellen die Luftzirkulation zwischen den Kühlmodulen und dem Schaltschranksystem sicher.

Selbstverständlich können nicht nur die Öffnungen in den Seitenwänden, dem Deckel oder im Sockel für das Anbringen der Kühlmodule genormt sein, sondern auch die Einschuböffnungen für die im Sockel angeordneten Kühleinheiten, beispielsweise Kühlkassetten.

Erfindungsgemäß stehen drei verschiedene Kühlmodulreihen mit abgestuften Kühlleistungen zur Verfügung, welche alle dieselben Abmessungen und Anbaueigenschaften aufweisen. Eine Ausnahme bildet das Filter-Luft-System 22, 24, bzw. 14, das jedoch auch auf die Normöffnungen 20 und 21 abgestimmt ist.

Nachfolgend werden die verschiedenen möglichen, anbaubaren Kühlmodule aufgeführt. Es sind dies
- für die Schaltschrankumfangswände:
   - ein Filter-Lüfter-System bestehend aus:
      Eintrittsfilter mit Lüfter 22 und
      Austrittfilter ohne Lüfter 24
   - ein Luft-Luft-Kühlmodul 30.1
   - ein Wasser-Luft-Kühlmodul 40.1 sowie
   - ein Kühl- oder Klimamodul 50.1
- für die Schaltschrankdeckelwand:
   - ein Dachaustrittsfilter 14, welcher zusammen mit dem
      Eintrittsfilter mit Lüfter 22 betrieben werden kann
   - ein Luft-Luft-Kühlmodul 30.2
   - ein Wasser-Luft-Kühlmodul 40.2
   - ein Kühl- oder Klimamodul 50.2
- für den Schaltschranksockel:
   - ein Luft-Luft-Kühlmodul 30.3
   - ein Luft-Wasser-Kühlmodul 40.3
   - ein Kühl- oder Klimamod7ul 50.3

In Fig. 1 ist eine erste Ausführungsform der Erfindung mit Schaltschrankkorpus 1 gezeigt, umfassend eine Deckelwand 3, Seitenwände 5, eine nicht dargestellte Rückwand sowie eine Frontwand, die vorliegend als Tür 7 ausgebildet ist

Der dargestellte Schaltschrank umfaßt des weiteren einen Sockel 9.

Bei der gezeigten Ausführung sind im Montagebereich 11 an der Frontwand 7, an einer Seitenwand 5 oder an der Deckelwand 3 zwei genormte Öffnungen 20, 21 vorgesehen, die eine Luftverbindung zwischen dem Schrankinneren und der Umgebung bzw. einem im Montagebereich angebrachten bzw. angeordneten Kühlmodul herstellen.

In der einfachsten Ausgestaltung der Erfindung ist vorgesehen, in diese Öffnung 21 einen Lüfter 22 und in die genormte Öffnung 20 einen Filter 24 einzusetzen. Der Lüfter bzw. die Lüftergruppe 22 saugen dann Umgebungsluft an, diese gelangt in das Schrankinnere, wird dort erwärmt und tritt über den Filter 24 wieder nach außen aus. Um Staub, Schmutzpartikel etc. zurückzuhalten, ist mit Vorteil vorgesehen, auch an der Lüfterbaugruppe im saugenden Bereich zur Umgebung zu ein Filtergewebe vorzusehen.

Die Ausgestaltung als Lüfter-Filter-System stellt die einfachste Möglichkeit einer Kühlung des Schrankinneren des Schaltschrankes 1 dar.

Werden höhere Kühlleistungen gefordert, so können anstelle des in die genormte(n) Öffnung(en) 20, 21 eingesetzten Lüfters bzw. Filters ergebend ein Lüfter-Filter-System im Montagebereich an der Seitenwand 7, der Türe 5 bzw. auf der Deckelwand 3 unterschiedliche Kühl- oder Klimamodule angeordnet werden. In einer ersten Ausgestaltung der Erfindung kann als Kühl- oder Klimamodul ein Luft-Luft-Wärmetauscher 30.1, 30.2 im Montagebereich 11 an der Seitenwand, der Tür oder auf dem Dach des Schaltschrankes angeordnet werden.

Der Luft-Luft-Wärmetauscher 30.1, 30.2, umfaßt zwei getrennte Kühlkreise, die thermisch über einen Wärmetauscher miteinander verbunden sind, nämlich einen Außenluftkreis sowie einen Innenluftkreis. Die Luft des Außenluftkreises wird bei einem an einer Schrankwand oder Seitenteil angeordneten Luft-Luft-Kühlmodul 30.1 von der im unteren Teil des Kühlmodules 30.1 angeordneten genormten Öffnung 32 zur Lüftereinrichtung 34 und von dort nach außen transportiert. Nicht dargestellt sind die im Kühlmodul 30.1 ebenfalls vorhandenen Elemente des zweiten Innenkreislaufes, die wiederum einen Lüfter umfassen, der dazu dient, über beispielsweise die genormte Öffnung 20 aus dem Schrankinneren Wärmeluft anzusaugen, die im Kühlmodul abgekühlt wird und über beispielsweise genormte Öffnung 21 wiederum an das Schrankinnere abgegeben wird. Ein auf dem Deckel angeordnetes Luft-Luft-Kühlmodul ist mit Bezugsziffer 30.2, ein im Sockelraum angeordnetes Luft-Luft-Kühlmodul mit 30.3 gekennzeichnet.

Das Ansaugen und Ausblasen der Umgebungsluft in das Sockelraum-Klimamodul 30.3 geschieht über die Vor- bzw. nicht dargestellte Rückseite. Das Ansaugen und Ausblasen der zu kühlenden Innenraumluft über Öffnungen 132 bzw. 134.

Alternativ zu einer Ausgestaltung als Luft-Luft-Wärmetauscher kann das Kühl- oder Klimamodul auch als Luft-Wasser-Wärmetauscher 40.1, 40.2, 40.3 ausgeführt sein.

Da eine Kühlung mittels angesaugter Umgebungsluft bei einem derartigen Kühl- oder Klimamodul nicht benötigt wird, sondern diese Aufgabe vielmehr von dem in das Kühl- oder Klimamodul eingespeisten Wasser übernommen wird, sind in der in Fig. 1 gezeigten Darstellung eines solchen Modules keinerlei Lüfterelemente bzw. Öffnungen für den Außenluftkreis zu erkennen. Selbstverständlich benötigt eine derartige Anordnung einen Lüfter sowie eine Öffnung für den Innenluftkreis zum Schrankinneren hin, der beim an die Schrank angebauten bzw. auf dem Deckel aufgebauten Luft-Wasser-Klimamodul nicht dargestellt ist.

Eine weitere Alternative für ein Kühl- oder Klimamodul ist ein sogenanntes Kompressor- bzw. Verflüssiger-Kühl- oder Klimamodul 50.1, 50.2, 50.3 oder ein Klimagerät mit Heizung 50.1, 50.2, 50.3.

Ein Kompressor-Kühlmodul 50.1, 50.2, 50.3 umfaßt einen Außenluftkühlkreis mit einer Lufteintrittsöffnung 52 sowie einer Ausblasöffnung 54. Im Innenkreislauf ist ein Verflüssiger vorgesehen, der über Öffnungen, die auf der Rückseite des Kühl- oder Klimamoduls angeordnet und nicht dargestellt sind, Luft in das Kühlmodul saugt und wiederum in das Innere des Schrankes abgibt. Die Luftzirkulation erfolgt dann wieder über die Normöffnungen des Schrankes 20 bzw. 21.

Die verschiedenen Kühl- oder Klimamodule können auch auf die Deckelwand des Schrankkorpus aufgesetzt werden, wie dargestellt.

Bei einem Ausfall des Kühlmodules kann daher auf einfache Art und Weise dieses entfernt werden. Eine Außerbetriebsetzung ist nicht vonnöten, da bei entferntem Kühlmodul 30, 40, 50 immer noch in die genormten Öffnungen 20, 21 eine Lüfter-Filter-Kühleinrichtung eingebaut werden kann, die in jedem Falle eine Notkühlung des Schaltschrankes sicherstellt. Auf diese Art und Weise kann bei Komponentenausfall ohne zeitliche Unterbrechung eine mit dem Schaltschrank gesteuerte Anlage weiterbetrieben werden.

Des weiteren wird aufgrund der genormten Öffnungen im Montagebereich der an dem Schaltschrank anzubringenden Kühl- oder Klimamodule eine einfache Tauschbarkeit erreicht, so daß Basiseinheiten, umfassend einen Schaltschrank, vorgefertigt werden können, die den Bedürfnissen des Anwenders entsprechend mit Kühlmodulen versehen wird.

In einer nicht dargestellten weitergebildeten Ausführungsform kann vorgesehen sein, daß nicht nur ein Kühl- oder Klimamodul am Schaltschrank angebracht wird, sondern mehrere, beispielsweise, daß ein Kühl- oder Klimamodul sowohl an der Frontwand wie an der Seitenwand angeordnet wird.

Der Sockelraum 9 des erfindungsgemäßen Schaltschranksystems kann entweder unbenutzt bleiben oder ebenfalls zu Kühl- oder Klimazwecken herangezogen werden, wie zuvor erwähnt.

Besonders vorteilhaft ist es, wenn der Sockelraum 9 mit einer Einschuböffnung 60 versehen ist, in die eine Kühl- oder Klimakassette eingeschoben wird. Die dargestellte Kühlkassette ist in einer ersten Ausgestaltung als Luft-Wasser-Wärmetauscher 40.3 ausgestaltet und weist dementsprechend zwei Wasseranschlüsse 68, 70 auf. Luft wird aus dem Schrankinneren über den Lüfter 142 angesaugt, die erwärmte Luft gibt ihre Wärme über Wärmetauscher an das Kühlwasser ab und wird dem Schrankinneren über eine in den vorliegenden Zeichnungen nicht dargestellte Öffnung wieder zugeführt. Selbstverständlich ist auch eine als Luft-Luft-Kühleinrichtung 30.3 oder Verflüssiger-/Kompressor-Kühl- oder Klimaeinrichtung 50.3 ausgestaltete Kühl- oder Klimakassette denkbar. Bei der Verflüssiger-/Kompressor-Kühl- oder Klimaeinrichtung wird die Umgebungsluft durch Öffnung 52 angesaugt und die nicht dargestellte Öffnung in der Rückseite ausgeblasen. Die zu kühlende Luft aus dem Schrankinneren wird über Lüfter 152 angesaugt und Öffnung 154 in das Schrankinnere geblasen.

Besonders bevorzugt ist es, wenn bei einer Ausgestaltung mit einer in den Sockel eingeschobenen Kühl- oder Klimakassette oder einem auf dem Dach angeordneten Kühl- oder Klimagerät das Schrankinnere eine zur Rückwand parallele Montageplatte aufweist. Durch eine derartige Ausgestaltung wird ein Zwischenraum zwischen Montageplatte und Rückwand ausgebildet.

Bei Geräten mit im Sockel eingelassenen Kühl- oder Klimamodulen strömt die von den Öffnungen 134, 144, 154 abgegebene gekühlte Luft im Schrankinneren zur Decke des Schaltschrankes, umströmt die Montageplatte und strömt im Zwischenraum wieder nach unten zum Lüfter 132, 142, 152. Auf diese Art und Weise wird eine vollständige Durchströmung des Schaltschrankes aufgrund einer Art Zwangsströmung bei Ausbildung mit einer Kühl- oder Klimakassette sichergestellt.

Bei Geräten mit auf der Decke angeordnetem Kühl- oder Klimamodul wird die gekühlte Luft in den Zwischenraum zwischen Montageplatte und Schrankrückwand eingeblasen, umströmt am Schrankboden die Montageplatte und wird durch das Schrankinnere in den Dachaufsatz zurückgesaugt.

In Fig. 2 ist eine alternative Ausführungsform der Erfindung mit nur einer genormten Öffnung an den Schrankseiten bzw. der Schranktüre, am Dachaufsatz und im Sockelbereich dargestellt. Für gleiche Bauteile bzw. Aggregte wie in Fig. 1 werden gleiche Betzugsziffem verwandt.

Auch das in Fig. 2 dargestellte System mit nur einer Öffnung erlaubt eine Vormontage der Schaltschränke, die je nach Einsatzort mit dem entsprechenden Kühl- oder Klimamodul ausgestaltet werden können. Als tauschbare Kühl- oder Klimamodule kommen die nachfolgenden Aggregate in Frage:
- ein Luft-Luft-Kühlmodul 30
- ein Luft-Wasser-Kühlmodul 40
- ein Klimagerät mit Verflüssiger/Kompressor oder Heizung 50

Ein besonderer Vorteil der vorliegenden Erfindung ist auch darin zu sehen, daß Kühl- oder Klimamodule unterschiedlicher Leistungsklassen leicht getauscht werden können und so eine hohe Flexibilität des Systems ermöglicht wird. Beispielsweise können ein 500W, 1000W, 1500 oder 2000 W-Kühl- oder Klimamodul vorgesehen sein, die je nach Einsatzort und -art an dem Schaltschrank angebracht werden.

Mit der vorliegenden Erfindung wird somit erstmals ein flexibles modulares System zur Schaltschrankkühlung zur Verfügung gestellt, das sich durch eine hohe Flexibilität sowie hohe Betriebssicherheit auch bei Ausfall von Kühlmodulen bzw. Kühlaggregaten auszeichnet.

## Patentansprüche

1. Modulares Schaltschranksystem zur Aufnahme elektrischer und/oder elektronischer Geräte;
mit einem ersten Modul, umfassend einen Schrankkorpus (1), der einen die Geräte enthaltenden Innenraum umschließt und einen Boden, eine Deckelwand (3) sowie Umfangswände aufweist, die ihrerseits zwei Seitenwände (5), eine Rückwand, sowie eine Frontwand umfassen, wobei innerhalb eines vorbestimmten Montagebereichs (11) in der Deckelwand (3), im Boden oder in den Umfangswänden des ersten Moduls mindestens eine Öffnung (20, 21) an einer vorbestimmten Stelle vorgesehen ist, die eine Luftverbindung zwischen einem auf dem vorbestimmten Montagebereich (11) aufgebrachten zweiten Modul und dem ersten Modul herstellt,
**dadurch gekennzeichnet, dass**
das Schaltschranksystem mindestens zwei zweite Module aufweist, welche jeweils mindestens eine der nachfolgenden Kühl- oder Klimaeinrichtungen oder eine Kombination aus mehreren derselben umfassen
- eine Luft-Luft-Kühleinrichtung (30)
- eine Luft-Wasser-Kühleinrichtung (40)
- eine Luft-Kälte-Kühleinrichtung
- eine Klimaeinrichtung mit Heizung
- eine Heat-Pipe-Kühleinrichtung
- eine Kälteelement-Kühleinrichtung;
und
dass die mindestens eine Öffnung (20, 21) des ersten Moduls derart genormt ausgestaltet ist, dass das eine zweite Modul durch das andere zweite Modul ausgetauscht am ersten Modul angeordnet werden kann, wobei mit jedem der zweiten Module eine vorbestimmte Mindestkühlleistung realisiert wird.

2. Schaltschranksystem zur Aufnahme elektrischer oder elektronischer Geräte gemäß Anspruch 1, **dadurch gekennzeichnet, daß** innerhalb des vorbestimmten Montagebereiches im Deckel, im Boden oder den Umfangswänden des ersten Moduls mindestens zwei genormten Öffnungen an einer vorbestimmten Stelle vorgesehen sind, die entweder wenigstens einen Lüfter sowie einen Filter aufnehmen und ein Filter-Lüfter-System ausbilden oder eine Luftverbindung zwischen einem auf dem vorbestimmten Montagebereich aufgebrachten Kühl- oder Klimamodul für den Schaltschrank herstellen.

3. Schaltschranksystem gemäß Anspruch 1 oder 2, **dadurch gekennzeichnet, daß** die genormte(n) Öffnung(en) in die Deckelwand eingebracht sind und das Kühl- oder Klimamodul als Dachaufsatz ausgebildet ist.

4. Schaltschranksystem gemäß einem der Ansprüche 1 bis 3, **dadurch gekennzeichnet, daß** die genormte(n) Öffnung(en) in eine Umfangswand eingebracht ist bzw. sind und das Kühlmodul als hängendes Gerät ausgebildet ist.

5. Schaltschranksystem gemäß einem der Ansprüche 2 bis 4, **dadurch gekennzeichnet, daß** die als Kühl- oder Klimamodule ausgebildeten Dachaufsätze oder hängenden Geräte in einem vorbestimmten Montagebereich, der dem Montagebereich des ersten Moduls entspricht, mindestens eine genormte Öffnung sowie Befestigungseinrichtungen umfassen.

6. Schaltschranksystem nach einem der Ansprüche 1 bis 5, **dadurch gekennzeichnet, daß** das Kühl- oder Klimamodul ein Luft-Luft-Kühlsystem ist.

7. Schaltschranksystem nach einem der Ansprüche 1 bis 5, **dadurch gekennzeichnet, daß** das Kühl-oder Klimamodul ein Luft-Wasser-Kühlsystem ist.

8. Schaltschranksystem nach einem der Ansprüche 1 bis 5, **dadurch gekennzeichnet, daß** das Kühl-oder Klimamodul ein Verflüssiger-Kompressor-Kühlsystem ist.

9. Schaltschranksystem nach einem der Ansprüche 1 bis 5, **dadurch gekennzeichnet, daß** das Kühl- oder Klimamodul eine Klimaeinrichtung mit Heizung umfaßt.

10. Schaltschranksystem gemäß einem der Ansprüche 1 bis 8, **dadurch gekennzeichnet, daß** das erste Modul einen Sockelraum umfaßt, in den die im Boden vorgesehene(n) genormte Öffnung(en) mündet bzw. münden.

11. Schaltschrank nach Anspruch 10, **dadurch gekennzeichnet, daß** das erste Modul im Sockelboden eine Einschuböffnung(en) für eine Kühl- oder Klimakassette aufweist.

12. Schaltschrank nach Anspruch 10, **dadurch gekennzeichnet, daß** die Kühl- oder Klimakassette eine Luft-Luft-Kühlkassette, eine Luft-Wasser-Kühlkassette, eine Luft-Verflüssiger-Kühlkassette oder eine Klimakassette ist.

13. Schaltschrank nach einem der Ansprüche 1 bis 12, **dadurch gekennzeichnet, daß** im Bereich einer Umfangswand eine zu dieser parallele Montageplatte vorgesehen ist, die zusammen mit der Umfangswand einen luftführenden Zwischenraum ausbildet.

## Claims

1. A modular switch cabinet for receiving electric and/or electronic devices; with a first module, comprising a cabinet body (1) enclosing an inner space containing the devices and a floor, a cover wall (3) and circumferential walls which on their part comprise two side walls (5), a back wall and a front wall, with at least one opening (20, 21) being provided at a predetermined location within a predetermined mounting area (11) in the cover wall (3), in the floor or in the circumferential walls of the first module, which opening (20, 21) produces an air connection between a second module applied to the predetermined mounting area (11) and the first module, **characterized in that**
the switch cabinet system comprises at least two second modules which each comprise at least one of the following cooling or air-conditioning devices or a combination of several of the same;
- an air-air cooling device (30);
- an air-water cooling device (40);
- an air-refrigerating cooling device;
- an air-conditioning device with heating;
- a heatpipe cooling device;
- a refrigerating element cooling device;
and that the at least one opening (20, 21) of the first module is configured in a standardized manner in such a way that the second module can be arranged on the first module by being exchanged by the other second module, with a predetermined minimum cooling output being realized with each of the second modules.

2. A switch cabinet system for receiving electric or electronic devices in accordance with claim 1, **characterized in that** within the predetermined mounting area in the cover, floor or the circumferential walls of the first module at least two standardized openings are provided at a predetermined location which receive either at least one fan and a filter and form a fan/filter system or produce an air connection between a cooling or air-conditioning module for the switch cabinet which is applied to the predetermined mounting area.

3. A switch cabinet system according to claim 1 or 2, **characterized in that** the standardized opening(s) is/are introduced into the cover wall and the cooling or air-conditioning module is configured as a roof turret.

4. A switch cabinet system according to one of the claims 1 to 3, **characterized in that** the standardized opening(s) is introduced into the circumferential wall and the cooling module is configured as a suspended device.

5. A switch cabinet system according to one of the claims 2 to 4, **characterized in that** the roof turrets or suspended devices arranged as cooling or air-conditioning modules in a predetermined mounting area which corresponds to the mounting area of the first module comprise at least one standardized opening and fastening devices.

6. A switch cabinet system according to one of the claims 1 to 5, **characterized in that** the cooling or air-conditioning module is an air-air cooling system.

7. A switch cabinet system according to one of the claims 1 to 5, **characterized in that** the cooling or air-conditioning module is an air-water cooling system.

8. A switch cabinet system according to one of the claims 1 to 5, **characterized in that** the cooling or air-conditioning module is a condenser/compressor cooling system.

9. A switch cabinet system according to one of the claims 1 to 5, **characterized in that** the cooling or air-conditioning module is an air-conditioning system with heating.

10. A switch cabinet system according to one of the claims 1 to 8, **characterized in that** the first module comprises a base chamber into which open(s) the standardized opening(s) as provided for in the floor.

11. A switch cabinet according to claim 10, **characterized in that** the first module in the base floor comprises an insert opening(s) for a cooling or air-conditioning cassette.

12. A switch cabinet according to claim 10, **characterized in that** the cooling or air-conditioning cassette is an air-air cooling cassette, an air-water cooling cassette, an air-condenser cooling cassette or an air-conditioning cassette.

13. A switch cabinet according to one of the claims 1 to 12, **characterized in that** in the region of a circumferential wall a mounting plate is provided which is parallel to the same and which forms an air-conducting intermediate space in combination with the circumferential wall.

## Revendications

1. Système modulaire pour armoires de commande destinées à recevoir des appareils électriques et/ou électroniques ;
avec un premier module comprenant un corps d'armoire (1) qui délimite un volume interne contenant les appareils et comporte un fond, une paroi de couvercle (3) ainsi que des parois périphériques, lesquelles comprennent pour leur part deux parois latérales (5), une paroi arrière ainsi qu'une paroi avant, au moins une ouverture (20, 21) étant prévue au sein d'une zone de montage (11 ) à un endroit prédéterminé de la paroi de couvercle (3), du fond ou des parois périphériques du premier module prédéterminée, cette ouverture permettant la circulation de l'air entre un deuxième module monté sur la zone de montage (11) prédéterminée et le premier module, **caractérisé en ce que**
le système d'armoire de commande comporte au moins deux deuxièmes modules comprenant chacun au moins une des installations de refroidissement ou de climatisation suivantes ou une combinaison de plusieurs d'entre elles
- une installation de refroidissement air-air (30)
- une installation de refroidissement air-eau (40)
- une installation de refroidissement air-froid
- une installation de climatisation avec chauffage
- une installation de refroidissement heat pipe
- une installation de refroidissement à élément frigorifique ;
et
que l'au moins une ouverture (20, 21) du premier module est normalisée de telle sorte que l'un des deuxièmes modules remplacé par l'autre deuxième module peut être disposé sur le premier module, une performance de refroidissement minimum prédéterminée étant obtenue avec chacun des deuxièmes modules.

2. Système d'armoires de commande destinées à recevoir des appareils électriques ou électroniques selon la revendication 1, **caractérisé en ce que** sont prévues, au sein de la zone de montage prédéterminée, à un endroit prédéterminé du couvercle, du fond ou des parois périphériques du premier module, au moins deux ouvertures normalisées, ces ouvertures soit recevant au moins un ventilateur ainsi qu'un filtre, formant ainsi un système filtre-ventilateur, soit permettant la circulation de l'air entre un module de refroidissement ou de climatisation monté sur la zone de montage prédéterminée et l'armoire de commande.

3. Système d'armoires de commande selon la revendication 1 ou 2, **caractérisé en ce que** l'ouverture normalisée (les ouvertures normalisées) est (sont) ménagée(s) dans la paroi du couvercle et que le module de refroidissement ou de climatisation est conformé pour être rapporté sur la paroi supérieure.

4. Système d'armoires de commande selon l'une quelconque des revendications 1 à 3, **caractérisé en ce que** l'ouverture normalisée (les ouvertures normalisées) est (sont) ménagée(s) dans une paroi périphérique et que le module de refroidissement est conformé sous forme d'appareil suspendu.

5. Système d'armoires de commande selon l'une quelconque des revendications 2 à 4, **caractérisé en ce que** les modules de refroidissement ou de climatisation conformés pour être rapportés sur la paroi supérieure ou conformés sous forme d'appareils suspendus comprennent, dans une zone de montage prédéterminée correspondant à la zone de montage du premier module, au moins une ouverture normalisée ainsi que des organes de fixation.

6. Système d'armoires de commande selon l'une quelconque des revendications 1 à 5, **caractérisé en ce que** le module de refroidissement ou de climatisation est un système de refroidissement air-air.

7. Système d'armoires de commande selon l'une quelconque des revendications 1 à 5, **caractérisé en ce que** le module de refroidissement ou de climatisation est un système de refroidissement air-eau.

8. Système d'armoires de commande selon l'une quelconque des revendications 1 à 5, **caractérisé en ce que** le module de refroidissement ou de climatisation est un système de refroidissement condenseur-compresseur.

9. Système d'armoires de commande selon l'une quelconque des revendications 1 à 5, **caractérisé en ce que** le module de refroidissement ou de climatisation comprend une installation de climatisation avec chauffage.

10. Système d'armoires de commande selon l'une quelconque des revendications 1 à 8, **caractérisé en ce que** le premier module comprend dans sa base un espace dans lequel débouche(nt) l'ouverture (les ouvertures) normalisée(s) prévue(s) dans le fond.

11. Armoire de commande selon la revendication 10, **caractérisée en ce que** le premier module comporte dans le fond de la base une ouverture (des ouvertures) d'insertion d'une cassette de refroidissement ou de climatisation.

12. Armoire de commande selon la revendication 10, **caractérisée en ce que** la cassette de refroidissement ou de climatisation est une cassette de refroidissement air-air, une cassette de refroidissement air-eau, une cassette de refroidissement air-condenseur ou une cassette de climatisation.

13. Armoire de commande selon l'une quelconque des revendications 1 à 12, **caractérisé en ce qu'**il est prévu, à la hauteur d'une paroi périphérique, une plaque de montage qui est parallèle à celle-ci et forme conjointement avec la paroi périphérique un espace intermédiaire de ventilation.
